# EUROPÄISCHE PATENTSCHRIFT

(11) **EP 2 147 584 B1**
(45) Veröffentlichungstag und Bekanntmachung des Hinweises auf die Patenterteilung: **02.11.2016**
(21) Anmeldenummer: 08735183.9
(22) Anmeldetag: 11.04.2008
(51) Int. Cl.: H05K 7/20

(54) **THERMOELEKTRISCHE TEMPERIERVORRICHTUNG**
THERMOELECTRIC TEMPERING DEVICE
DISPOSITIF D'ÉQUILIBRAGE DE TEMPÉRATURE THERMOÉLECTRIQUE

(30) Priorität: 12.04.2007 DE 202007018397 U
(43) Veröffentlichungstag der Anmeldung: 27.01.2010
(73) Patentinhaber: RITTAL GmbH & Co. KG, 35745 Herborn (DE)
(72) Erfinder: BRAUN, Ralf, 79183 Waldkirch (DE); BELL, Lon E., Atlanta, CA 91001 (US); DILLER, Robert W., Pasadena, CA 91107 (US); REITZ, Christoph, 35713 Eschenburg (DE)
(74) Vertreter: Angerhausen, Christoph
(86) Internationale Anmeldenummer: PCT/EP2008/002890
(87) Internationale Veröffentlichungsnummer: WO 2008/125301

(56) Entgegenhaltungen:
- DE-U1- 20 007 920
- DE-U1-202005 009 581
- US-A- 5 431 021
- US-B1- 6 301 901

## Beschreibung

Die Erfindung betrifft eine thermoelektrische Temperiervorrichtung mit mehreren thermoelektrisch arbeitenden Temperierelementen mit einer sich bei Zuführung elektrischen Stroms bildenden kalten Fläche auf ihrer einen Seite und einer warmen Fläche auf ihrer gegenüberliegenden Seite, mit auf beiden Seiten aufgebrachten, in einer jeweiligen Luftströmungskammer untergebrachten Luft-Wärmetauscherkörpern und mit eine Luftströmung entlang denselben bewirkenden Lüftern, wobei eine als Temperiermodul ausgestaltete Einheit der Temperiervorrichtung, das in einem Gehäuse mit Gehäuseunterteil und Gehäuseoberteil untergebracht ist, in der Weise aufgebaut ist, dass die Luftströmungskammern als die Wärmetauschkörper in Strömungsrichtung seitlich und auf deren von den Temperierelementen abgewandter Seite umgebende Strömungskanäle ausgebildet sind, die eine Luft-Einströmöffnung und eine Luft-Ausströmöffnung aufweisen, wobei der Lüfter des jeweiligen Strömungskanals an dessen Einströmöffnung oder an dessen Ausströmöffnung angeordnet ist, wobei die Temperierelemente, die Wärmetauschkörper und die Lüfter in dem Gehäuseunterteil angeordnet und gehalten sind und auch die Strömungskanäle in dem Gehäuseunterteil angeordnet sind.

Eine thermoelektrische Temperiervorrichtung dieser Art ist in der US 5,431,021 angegeben. Bei dieser bekannten thermoelektrischen Temperiervorrichtung sind mehrere thermoelektrisch arbeitende Temperierelemente mit bei Zuführung elektrischen Stroms kalter Fläche auf ihrer einen Seite und warmer Fläche auf ihrer anderen Seite mit auf beiden Seiten aufgebrachten Lamellen-Wärmetauschkörpern versehen und in einem Temperiermodul mit Gehäuse zusammengefasst. Näher gezeigt ist dabei eine Anordnung der beiderseitigen Wärmetauschkörper mit gekreuzter Anordnung ihrer Lamellen, wodurch sich auch entsprechende Strömungskanäle ergeben.

Die DE 20 2005 009 581 U1 zeigt eine thermoelektrische Temperiervorrichtung, die in die Wand eines Gehäuses eingebaut ist, um elektronische Bauteile zu kühlen.

Die US 6,301,901 B1 zeigt eine thermoelektrische Temperiervorrichtung mit einem in eine Kühlbox einsetzbaren Temperiermodul.

Eine weitere Temperiervorrichtung ist in der DE 200 07 920 U1 im Zusammenhang mit einer Belüftungsvorrichtung für ein Gehäuse, beispielsweise Schaltschrank mit elektronischen Einrichtungen angegeben. Diese bekannte, als Dacheinheit ausgeführte Belüftungsvorrichtung ist als flache, quaderförmige Einheit mit mehreren Luftströmungskammern ausgeführt und weist u.a. eine Wärmeübertragungseinrichtung mit mindestens einem Peltier-Element auf, das je nach gewählter elektrischer Stromflussrichtung auf einer Fläche vorbeiströmende Luft kühlen oder anwärmen kann, während die andere Fläche umgekehrt abgekühlt bzw. erwärmt wird. Dieser aktiv arbeitenden Peltier-Wärmeübertragungseinrichtung ist eine separate Strömungskammer mit einem Wärmetauscher im Strömungsweg vorgelagert, dem wiederum ein Radiallüfter zum Zuführen eines internen Luftstroms vorgeschaltet ist. Der interne Luftstrom wird in dem Wärmetauscher mit einem externen Luftstrom zum Wärmeaustausch gekreuzt, bevor dann die Luft zu der Peltier-Wärmeübertragungseinrichtung gelangt und anschließend einerseits mittels eines Axiallüfters in die Umgebung abgeführt und andererseits als temperierte Luft in den Schaltschrank geführt wird. Bei dieser Ausbildung wirkt die Peltier-Wärmeübertragungseinrichtung unterstützend im Zusammenhang mit weiteren Temperierkomponenten der Belüftungsvorrichtung, insbesondere dem vorgelagerten Wärmetauscher. Die gesamte Belüftungsvorrichtung bildet zusammen mit den Luftströmungskammern eine relativ voluminöse Einheit.

Bei einem in der nicht vorveröffentlichten deutschen Patentanmeldung Nr. 10 2006 020 499.9 gezeigten weiteren thermoelektrischen Temperiervorrichtung mit Peltier-Elementen wird eine Steigerung des Wirkungsgrades bei flacher, kompakter Ausbildung dadurch erreicht, dass ein Strömungskanal in eine Mehrzahl von Teil-Strömungskanäle mündet, welche zu den Wärmetauscherelementen führen, um einen Wärmeübertrag mit durchströmender Luft zu bewirken.

Die US 2006/0137359 A1 zeigt eine thermoelektrische Temperiervorrichtung zum Kühlen oder Wärmen mit mehreren Peltier-Element-Modulen. Über die kalten und warmen Flächen sind geschlossene Kreisläufe mit einem Wärmeübertragungsfluid, z. B. Flüssigmetall, geführt, wobei in den Kreisläufen auch ein Wärmetauscher angeordnet sein kann. Eine Lüftervorrichtung mit geeigneten Kühlkanälen ist bei diesem Aufbau nicht vorgesehen.

Die DE 102 18 343 B4 zeigt eine elektrische Temperiervorrichtung mit Peltier-Elementen für Fahrzeuge. Hierbei wird nur die eine Seite der Peltier-Elemente einer in einem umgebenden Kanal erzeugten Luftströmung ausgesetzt, die in den Innenraum des Fahrzeugs geleitet wird, während die andere (kühle) Seite in thermischem Kontakt mit Leistungsbauteilen der Ansteuereinheit steht. Auf der zweiten Seite ist demgemäß kein entsprechender Kühlkanal und betreffende Lüfteranordnung vorhanden.

Eine weitere thermoelektrische Temperiervorrichtung mit Peltier-Elementen zum Kühlen oder Wärmen geht aus der JP 2000130909 A hervor. Hierbei sind mit unterschiedlicher Leistung ansteuerbare Lüfter vorgesehen. Diese sind jedoch auf der Außenseite eines Gehäuses auf einer Peltier-Einheit und senkrecht zu deren Fläche gerichtet angeordnet.

Eine weitere thermoelektrische Temperiervorrichtung mit mehreren thermoelektrisch arbeitenden Temperierelementen ist in der US 6,181,556 B1 angegeben. Bei dieser bekannten thermoelektrischen Temperiervorrichtung sind mehrere Peltier-Elemente auf nur einer Seite mit Lamellen aufweisenden Kühlkörpern und auf diesen aufgebrachten Ventilatoren zusammengebracht, um eine Prozessoreinheit CPU oder ein anderes Halbleiterbauelement zu kühlen, die/das auf einer Platine angeordnet und in besonderer Weise mit der Kühlvorrichtung in Verbindung gebracht bzw. von dieser umbaut ist. Zur Kühlung ist des Weiteren eine wärmegekoppelte Brücke vorgesehen. Mit diesem Aufbau ist es schwierig, eine definierte Luftströmung zu erreichen.

Auch die DE 200 13 775 U1 zeigt eine thermoelektrische Temperiervorrichtung, nämlich Kühlvorrichtung, mit Peltier-Elementen. Hierbei sind auf der warmen und der kalten Seite des Peltier-Elements Kammern mit Lüftern angeordnet, wobei zwischen der warmen Seite und dem betreffenden Lüfter ein Kühlkörper angeordnet ist, der die produzierte Wärme an die Umgebungsluft abgibt, und wobei zwischen der kalten Seite und dem betreffenden Lüfter ein weiterer Kühlkörper angeordnet ist, welcher Lamellen aufweist, um mit dem Lüfter die Kälte von dem Kühlkörper in dem zu kühlenden Gerät zu verteilen. Auch hierbei ist es schwierig, definierte Strömungsverhältnisse bei unterschiedlichen Einbaumöglichkeiten zu erreichen.

Der Erfindung liegt die Aufgabe zugrunde, eine thermoelektrische Temperiervorrichtung der eingangs genannten Art bereit zu stellen, die von Anwendern für verschiedene Zwecke mit möglichst wenig Aufwand, insbesondere zum Kühlen von Schaltschränken oder Gehäusen einsetzbar ist.

Diese Aufgabe wird mit den Merkmalen des Anspruches 1 gelöst.

Diese Maßnahmen ergeben einen kompakten Aufbau in modularer Bauweise, der einfache Erweiterungs- und Anpassungsmöglichkeiten an unterschiedliche Anforderungen bietet. Beispielsweise ergeben sich durch die raumsparende, kompakte Bauform vorteilhafte Einbaumöglichkeiten in einem elektronische Einbaukomponenten aufweisenden Schaltschrank oder auch kleineren Gehäuse. Darüber hinaus sind weitere Anwendungen, wie z. B. eine Kühlung von Oberflächen oder Substanzen unterschiedlicher Art möglich. Neben der kompakten, flachen und dabei kostengünstigen Bauweise ergibt sich ein hoher Wirkungsgrad im Vergleich zu Geräten in herkömmlicher Bauweise und ein geringes Gewicht. Die Temperierung kann dabei, wie an sich bekannt, in einer Kühlung oder einer Erwärmung der vorbei geführten Luft bestehen, je nach gewählter elektrischer Stromrichtung der betreffenden Temperierelemente.

Verschiedene Ausgestaltungsvarianten der Bauform bestehen darin, dass die Lüfter seitlich neben dem betreffenden Wärmetauschkörper beide auf der gleichen Seite oder auf gegenüberliegenden Seiten des Temperiermoduls integriert sind.

Ein flacher, kompakter Aufbau und ein hoher Wirkungsgrad werden dadurch begünstigt, dass die Lüfter beide als Radiallüfter ausgebildet sind, deren radialseitige Strömungsöffnung dem jeweiligen Wärmetauschkörper zugekehrt ist und deren axialseitige Strömungsöffnung senkrecht zur Flachseite der Temperierelemente gerichtet ist, wobei die radialseitige Strömungsöffnung seitlich neben dem jeweiligen Wärmetauschkörper angeordnet ist, oder dass die Lüfter als Axiallüfter ausgebildet sind und der jeweilige Strömungskanal in seinem dem betreffenden Axiallüfter zugekehrten Bereich eine in der Achsenrichtung des Radiallüfters zeigende Richtungskomponente aufweist.

Verschiedene weitere Aufbauvarianten bestehen darin, dass beide Lüfter als blasende, beide als saugende oder einer als saugender und der andere als blasender Lüfter bezüglich des zugehörigen Strömungskanals ausgebildet sind.

Für die Wirkungsweise und variable Anordnungsmöglichkeiten günstige weitere Ausgestaltungen bestehen darin, dass der der kalten Fläche zugeordnete Strömungskanal einerseits und der der warmen Fläche zugeordnete Strömungskanal andererseits im Gegenstrom oder im Gleichstrom von der Luft durchströmt werden.

Ein für einen möglichst hohen Wirkungsgrad vorteilhafter Aufbau ergibt sich dadurch, dass die Wärmetauschkörper senkrecht zu der kalten oder warmen Fläche und parallel zur Luftströmung durch den betreffenden Strömungskanal orientierte Lamellen aufweisen.

Die Temperierleistung z. B. für einen Schaltschrank oder größere Gehäuse mit hohe Verlustleistung produzierenden Verbrauchern kann dadurch vorteilhaft gesteigert werden, dass eine als Temperiermodul aufgebaute Einheit der Temperiervorrichtung an mindestens einem Randabschnitt im Bereich des Umfangsrandes mit einer Koppelvorrichtung versehen ist, über die ein entsprechend ausgebildetes, eine komplementäre Koppelvorrichtung aufweisendes weiteres Temperiermodul anschließbar ist. Eine sichere Kopplung wird dadurch erreicht, dass jedes Temperiermodul an einem Randabschnitt eine Koppelvorrichtung und an einem anderen Randabschnitt eine komplementäre Koppelvorrichtung aufweist.

Vorteilhafte Erweiterungsmöglichkeiten werden dadurch erhalten, dass jedes Temperiermodul an einem Randabschnitt eine Koppelvorrichtung und an einem anderen Randabschnitt eine komplementäre Koppelvorrichtung aufweist. Die äußere Kontur des Temperiermoduls kann unterschiedlich sein, ist aber vorteilhaft in Draufsicht rechteckförmig oder quadratisch ausgeführt, so dass sich z. B. mit auf gegenüberliegenden Seiten eines Temperiermoduls an den schmalen Randabschnitten angeordneter Koppelvorrichtung und komplementärer Koppelvorrichtung einfache Erweiterungsmöglichkeiten durch Anreihung weiterer Temperiermodule und damit eine Kaskadierung und Skalierung der Temperierleistung ergeben.

Zu einem einfach aufbaubaren Zusammenschluss mehrerer Temperiermodule tragen die Maßnahmen bei, dass die Koppelvorrichtung mechanische Koppelmittel und elektrische Koppelkomponenten aufweist, und ferner die Maßnahmen, dass die elektrischen Koppelkomponenten mindestens eine Stecker-/Kupplungseinheit für die elektrische Kopplung von Signalleitungen und/oder Versorgungsleitungen aufweisen.

Verschiedene Ausgestaltungsvarianten bestehen dabei darin, dass die mechanischen Koppelmittel Steck-, Rast-, Schraub- und/oder Magnetverbindungselemente aufweisen.

Der Aufbau und der Betrieb der Temperiervorrichtung werden dadurch begünstigt, dass eine Steuereinrichtung mit einem Steuermodul vorhanden ist, die mit einem oder einer Gruppe von Temperiermodulen in elektrische Verbindung gebracht oder bringbar ist und die so ausgebildet ist, dass ein Temperiermodul und/oder mehrere Temperiermodule im Verbund mit unterschiedlicher Temperierleistung steuerbar oder regelbar sind.

Zu variablen Einsatz- und Betriebsmöglichkeiten tragen auch die Merkmale bei, dass die Steuereinrichtung so ausgebildet ist, dass unterschiedliche Temperierleistungen durch unterschiedliche Ansteuerung der Lüfter und/oder durch unterschiedliche Steuerung der Stromzuführung zu den Temperierelementen steuerbar oder einregelbar sind.

Ist vorgesehen, dass die Temperiermodule mittels der Steuereinrichtung untereinander unterschiedlich steuerbar sind, so ergeben sich weitere vorteilhafte Steuermöglichkeiten der Temperierung.

Zu einer effizienten Temperierung tragen die Maßnahmen bei, dass die Steuereinrichtung zum Ansteuern der Lüfter mit unterschiedlicher elektrischer Leistung und zum Ansteuern der Temperierelemente mit unterschiedlicher elektrischer Leistung ausgebildet ist, um unterschiedlichen Temperierleistungsbedarf abzudecken, und dass die Ansteuerung der Lüfter und die Ansteuerung der Temperierelemente in der Weise aufeinander abgestimmt sind, dass der Gesamtbedarf an elektrischer Leistung für die Ansteuerung der Lüfter und der Temperierelemente bei der jeweiligen Temperierleistung minimal ist. Hierzu ist die Ausbildung vorteilhaft derart, dass die Steuereinrichtung mindestens eine als Mikrokontroller ausgebildete Steuereinheit aufweist, in der Programme zum Bereitstellen der Signale für die Ansteuerung der Lüfter und der Temperierelemente in Abhängigkeit von den Temperierleistungsbedarf vermittelnden Sensorsignalen hinterlegt sind.

Eine Anpassung an unterschiedliche Anforderungen wird ferner dadurch begünstig, dass eine elektrische Energieversorgung mit mindestens einem Energieversorgungsmodul vorhanden ist, das oder die zur wahlweisen Versorgung eines einzelnen Temperiermoduls oder einer Gruppe von Temperiermodulen ausgebildet ist/sind.

Ein vorteilhafter Aufbau ergibt sich dabei dadurch, dass die Steuereinrichtung mindestens ein Steuermodul mit eigenem Gehäuse aufweist und dass das Steuermodul und/oder das oder die Versorgungsmodule ebenfalls mit einer Koppelvorrichtung zur elektrischen und/oder mechanischen Kopplung mit einem oder mehreren Temperiermodulen versehen ist/sind.

Ein für die Funktion und Anwendung vorteilhafter Aufbau besteht darin, dass das Temperiermodul ein Gehäuse mit Gehäuseunterteil und Gehäuseoberteil aufweist und dass die Temperierelemente, die Wärmetauschkörper und die Lüfter in dem Gehäuseunterteil angeordnet und gehalten sind.

Eine günstige Ausbildung ergibt sich dabei dadurch, dass die Strömungskanäle in dem Gehäuseunterteil angeordnet sind.

Für die Herstellung, Funktion und Anwendbarkeit sind dabei die Maßnahmen von Vorteil, dass das Gehäuseunterteil quaderförmig ausgeführt ist und mit einem auf seiner Unterseite abnehmbar angebrachten Gehäuseboden versehen und auf seiner gegenüberliegenden Oberseite mit dem Gehäuseoberteil abgedeckt ist, dass in dem Gehäuseboden eine Einströmöffnung und eine mit dieser über einen gegebenenfalls mehrere Zweigkanäle umfassenden Strömungskanal in Strömungsverbindung stehende Ausströmöffnung angeordnet sind und dass in dem Gehäuseoberteil eine weitere Einströmöffnung und eine mit dieser über einen anderen gegebenenfalls mehrere Zweigkanäle umfassenden Strömungskanal in Verbindung stehende weitere Ausströmöffnung angeordnet sind.

Ein kompakter Aufbau mit guter Handhabbarkeit wird dabei dadurch begünstigt, dass das Gehäuseoberteil nach außen auf der Oberseite haubenartig vorsteht und im Längsschnitt trapezförmig oder nach außen konvex gewölbt geformt ist und dass zwischen einem mittleren Abschnitt des Gehäuseoberteils und einer Zwischenwand am zugekehrten oberen Bereich des Gehäuseunterteils eine Aufnahmekammer gebildet ist, in der eine elektrische Energieversorgung, insbesondere ein Netzteil, untergebracht ist.

Für die Fertigung mit vorteilhafter Einbringung und Anpassung der Strömungskanäle in Abstimmung auf die übrigen Elemente der Luftführung und Temperierung wird dadurch begünstigt, dass in dem Gehäuseunterteil ein in seinen Außenkonturen quaderförmiger Gehäuseeinsatz eingesetzt ist, in dem die Strömungskanäle ausgebildet sind, wobei der Gehäuseeinsatz z. B. aus temperaturbeständigem, stabilem Kunststoffmaterial hergestellt ist.

Zu einem kompakten, gut handhabbaren Aufbau tragen ferner die Maßnahmen bei, dass der Gehäuseeinsatz gegenüber dem Gehäuseunterteil in seiner Längsrichtung verkürzt ist und dass in dem Raum zwischen einer schmalen Außenseite des Gehäuseeinsatzes und der zugewandten schmalen Innenseite des Gehäuseunterteils die Steuereinheit aufgenommen ist.

Weitere Vorteile für die Funktion und die Anwendung ergeben sich daraus, dass in einer oberen Deckwand des Gehäuseoberteils eine optische Anzeigevorrichtung eingebaut ist.

Die Erfindung wird nachfolgend anhand von Ausführungsbeispielen unter Bezugnahme auf die Zeichnungen näher erläutert. Es zeigen:
- Fig. 1: ein in einer Schaltschrankwand eingebautes Temperiermodul im Längsschnitt in schematischer Darstellung,
- Fig. 2: ein Temperiermodul nach Fig. 1 in perspektivischer Darstellung,
- Fig. 3: ein weiteres Ausführungsbeispiel für ein Temperiermodul im Längsschnitt in schematischer Darstellung,
- Fig. 4: ein weiteres Ausführungsbeispiel für ein in einer Schaltschrankwand eingebautes Temperiermodul im Längsschnitt in schematischer Darstellung,
- Fig. 5: das Temperiermodul nach Fig. 4 in perspektivischer Ansicht,
- Fig. 6: mehrere zu einer Einheit zusammenzusetzende Temperiermodule in schematischer Darstellung,
- Fig. 7: mehrere zu einer Einheit zusammenzusetzende Temperiermodule sowie zuzuordnende elektrische Versorgungsmodule in Draufsicht in schematischer Darstellung,
- Fig. 8: mehrere zu einer Einheit zusammensetzbare Temperiermodule, ein Steuerungsmodul und ein elektrisches Versorgungsmodul in schematischer Darstellung,
- Fig. 9: mehrere zu einer Einheit zusammenzusetzende Temperiermodule mit einer Koppelvorrichtung in schematischer Darstellung,
- Fig. 10: einen Längsschnitt eines auf einer Gehäusewand aufgesetzten Temperiermoduls in anderer Ausführung in schematischer Darstellung,
- Fig. 11: einen Längsschnitt einer weiteren Ausführungsform eines Temperiermoduls nach Fig. 10 in perspektivischer Darstellung,
- Fig. 12A und 12B: das Temperiermodul nach Fig. 11 in perspektivischer Ansicht von der Unterseite und der Oberseite,
- Fig. 13A bis 13G: verschiedene Ansichten des Temperiermoduls nach Fig. 11, nämlich in Draufsicht, im Längsschnitt, in einer Ansicht von rechts und in zwei Querschnittdarstellungen entlang Schnittebenen B-B und C-C sowie in seitlicher Ansicht,
- Fig. 14: das Temperiermodul nach Fig. 11 in auseinander gezogener perspektivischer Darstellung,
- Fig. 15: das Temperiermodul in einem an einem Gehäuse angebauten Zustand in perspektivischer Darstellung,
- Fig. 16: das Gehäuse nach Fig. 15 mit angebautem Temperiermodul mit Blick auf die Innenseite des Gehäuses bei geöffneter Tür,
- Fig. 17: ein in einem Gehäuse bis auf ein Oberteil eingebautes Temperiermodul in perspektivischer Ansicht und
- Fig. 18: eine schematische Blockbilddarstellung einer Steuereinrichtung für die Temperiervorrichtung.

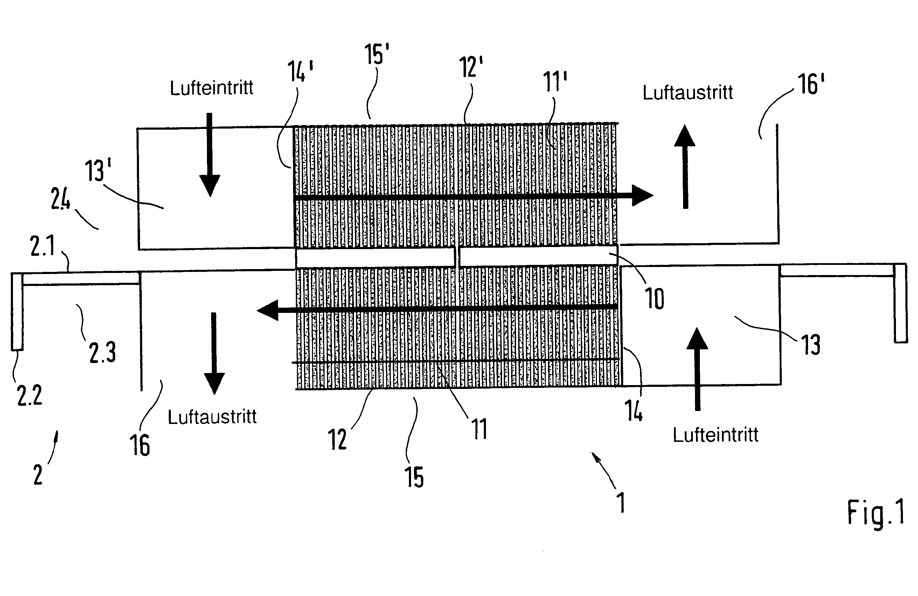

Fig. 1 zeigt ein in einer Rückwand 2.1 eines Schaltschranks 2 eingebautes Temperiermodul 1 einer thermoelektrischen Temperiervorrichtung. Ein Teil des Temperiermoduls 1 ist innerhalb des von Seitenwänden 2.2 seitlich begrenzten Innenraums 2.3 des Schaltschranks 2 angeordnet, während der andere Teil in dem Außenraum 2.4 des Schaltschranks 2 liegt. Mit dem dem Innenraum 2.3 zugewandten Teil des Temperiermoduls 1 wird die Innenluft des Schaltschranks 2 temperiert, um z. B. die durch die Verlustwärme von elektrischen Bauteilen erwärmte Innenluft zu kühlen und auf einem bestimmten Temperaturniveau zu halten. Ist die Innenraumtemperatur zu niedrig, kann mit dem Temperiermodul 1 durch Umkehrung der Stromrichtung auch eine Anwärmung der Innenraumluft bewirkt werden. Ähnliche Einbauten des Temperiermoduls 1 sind auch bei kleineren Innenräumen, wie z. B. in Gehäusen, möglich und auch eine Verwendung des Temperiermoduls 1 in Verbindung mit zu kühlenden Oberflächen oder Materialien anderer Art ist möglich.

Das Temperiermodul 1 weist vorzugsweise mehrere thermoelektrische Elemente, insbesondere Peltier-Elemente 10 auf, die in an sich bekannter Weise beim Durchfluss elektrischen Stroms auf ihrer einen Flachseite Kälte und auf ihrer anderen Flachseite Wärme erzeugen. Durch Umkehrung der Stromrichtung können die kalte Seite und die warme Seite vertauscht werden.

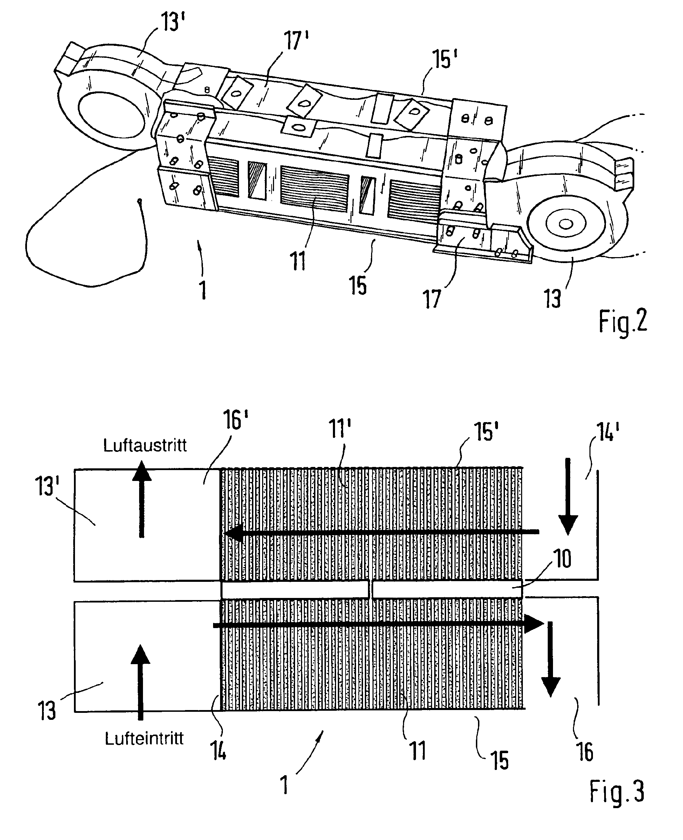

Auf der kalten Fläche und auf der warmen Fläche der Temperierelemente 10 sind Wärmetauschkörper 11 bzw. 11' mit senkrecht zu der jeweiligen Fläche stehenden Lamellen aufgebracht, die in Fig. 1_ (und auch den Fig. 3, 4, 6) aus Gründen der Darstellung der Lamellenform senkrecht zur Zeichenebene dargestellt sind, in Wirklichkeit aber parallel zur mit den Pfeilen angegebenen Strömungsrichtung der durch den Wärmetauschkörper 11 bzw. 11' hindurch geführten Luft angeordnet sind. Der Wärmetauschkörper 11, 11' ergibt vermittels der Lamellen einen Wärmeaustausch zwischen den betreffenden Flächen der Temperierelemente 10 mit hohem Wirkungsgrad, insbesondere wenn der Wärmetauschkörper 11, 11' aus einem gut wärmeleitfähigen Material wie Aluminium oder Kupfer besteht.

Die Wärmetauschkörper 11, 11' sind jeweils in einem ihn auf der von der kalten bzw. warmen Fläche der Temperierelemente 10 abdeckenden Seite sowie auf beiden zur Strömungsrichtung der durch die Lamellen strömenden Luft parallel verlaufenden Seiten mit einer jeweiligen Kanalabdeckung 12, 12' und seitlichen Wandabschnitten in geringem Abstand umgeben, um einen jeweiligen Strömungskanal 15, 15' zu bilden, der eine wirkungsvolle Führung der Luft zur Durchströmung des Wärmetauschkörpers 11, 11' entlang der Lamellenflächen ergibt, wobei der Strömungskanal parallel zu der kalten bzw. warmen Fläche der Temperierelemente 10 verläuft und in einer senkrecht zu der kalten bzw. warmen Fläche der Temperierelemente 10 und quer zur Strömungsrichtung orientierten Ebene auf seiner einen Seite eine Luft-Einströmöffnung 14 bzw. 14' und auf seiner davon abgelegenen Endseite eine Luft-Ausströmöffnung 16, 16' aufweist. Auf der Luft-Einströmseite des Strömungskanals 15 bzw. 15' ist jeweils ein Lüfter 13 bzw. 13' angebracht, mit dem Luft durch den jeweiligen Strömungskanal 15, 15' mit dem Wärmetauscher 11 bzw. 11' geblasen wird, die nach Ausströmen aus der Luft-Ausströmöffnung 16, 16' einerseits in den Innenraum 2.3 des Schaltschranks temperiert austritt und andererseits in den Außenraum 2.4 geführt wird. Die Lüfter 13, 13' sind z. B. als Radiallüfter ausgebildet, die Luft axial einsaugen und durch eine radialseitige Öffnung, mit der sie an den Strömungskanal 15 bzw. 15' dicht angeschlossen sind, Luft in den Strömungskanal einblasen. Auf diese Weise wird die zu temperierende Luft im Innenraum 2.3 des Schaltschranks 2 mit hohem Wirkungsgrad auf die erforderliche Temperatur gebracht. Ferner ergibt sich durch diesen Aufbau eine kompakte, relativ flache Bauweise.

Wie Fig. 2 zeigt, sind die Lüfter 13 bzw. 13' mittels eines jeweiligen Kanalabschnitts 17, 17' an den Strömungskanal 15, 15' angekoppelt. Auch an der Luft-Ausströmöffnung 16, 16' sind ähnliche Kanalabschnitte ausgebildet, wobei über die ausströmseitigen Kanalabschnitte die Luft z. B. senkrecht zu der in dem Strömungskanal 15 bzw. 15' vorherrschenden Strömungsrichtung herausgeführt werden kann, wie es umgekehrt auch auf der Eingangsseite der Fall ist, wo die Luft senkrecht zur Strömungsrichtung in dem Kanal in den betreffenden Lüfter 13, 13' eintritt.

Bei dem Ausführungsbeispiel nach den Fig. 1 und 2 sind der der kalten Fläche einerseits und der der warmen Fläche der Temperierelemente 10 andererseits zugeordnete Lüfter auf entgegen gesetzten Seiten des Strömungskanal 15 bzw. 15' angeordnet und die Strömungsrichtung ist wegen der jeweils blasenden Ausführung der Lüfter 13, 13' in den beiden Wärmetauschkörpern 11, 11' entgegengesetzt, wie die Strömungspfeile zeigen.

Bei dem in Fig. 3 gezeigten Ausführungsbeispiel des Temperiermoduls 1 ist ebenfalls ein derartiges Gegenstromprinzip angewandt. Im Unterschied zu dem Ausführungsbeispiel nach den Fig. 1 und 2 ist der eine Lüfter, vorliegend der dem Innenraum des Schaltschranks zugeordnete Lüfter, als blasender Radiallüfter ausgeführt, während der andere, vorliegend der dem Außenraum 2.4 zugeordnete Lüfter 13' als saugender Radiallüfter ausgeführt ist, wobei die Luft durch die radialseitige Öffnung des Lüfters durch die Luft-Einströmöffnung 14' und den Strömungskanal 15' sowie die Luft-ausströmöffnung 16' angesaugt und durch den Lüfter 13' axial nach außen geführt wird.

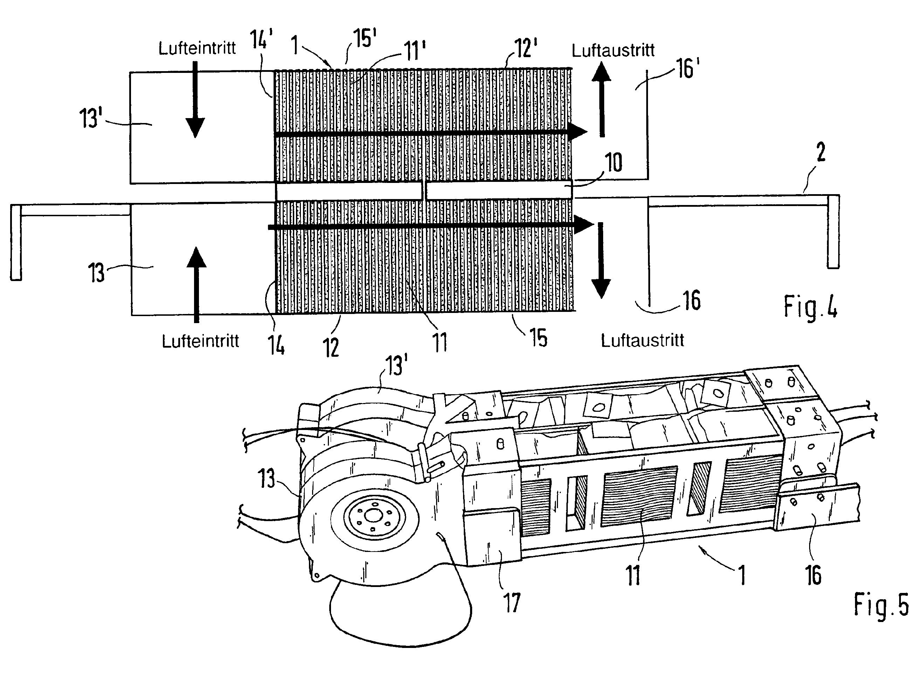

Bei dem in den Fig. 4 und 5 gezeigten Ausführungsbeispiel des beispielsweise in die Rückwand des Schaltschranks 2 eingebauten Temperiermoduls 1 sind die beiden Lüfter 13, 13' der kalten bzw. warmen Fläche der Temperierelemente 10 ebenfalls auf der gleichen Seite des Temperiermoduls 1 an dem jeweiligen Strömungskanal 15, 15' angeschlossen. Hierbei sind beide Lüfter 13, 13' wiederum als blasende Lüfter, vorzugsweise Radiallüfter ausgeführt, so dass ein Aufbau des Temperiermoduls 1 erhalten wird, der nach dem Gleichstrom-Prinzip arbeitet, wie die in Fig. 4 eingezeichneten Strömungspfeile zeigen. Hierdurch ergibt sich wegen der Anordnung der blasenden Lüfter auf der gleichen Seite des Temperiermoduls 1 eine kompaktere Bauweise als bei dem Ausführungsbeispiel nach Fig. 1, jedoch ein in der Regel geringerer Wirkungsgrad als bei dem Gegenstrom-Prinzip, bei dem eine konstantere Temperaturverteilung über die gesamte Querstrecke vorherrscht.

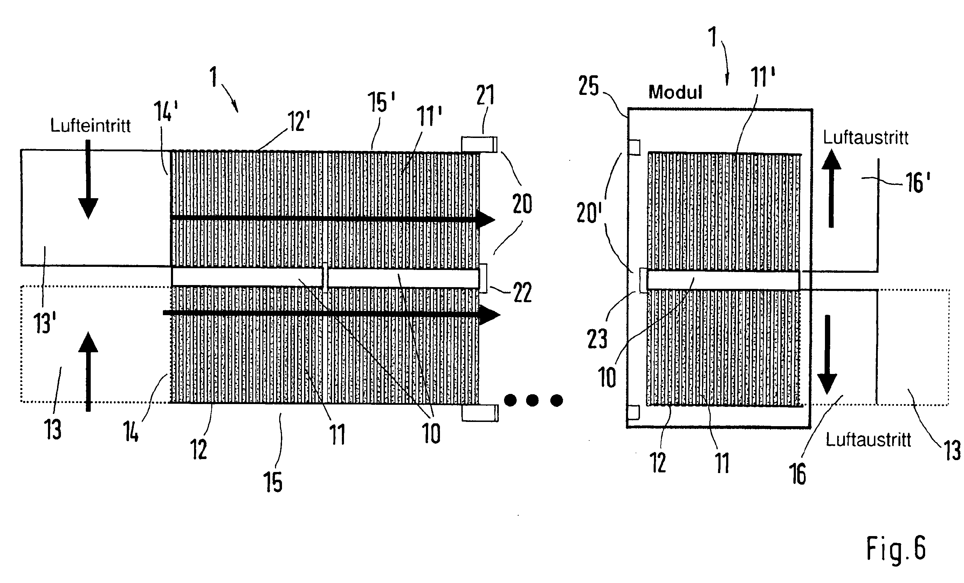

Fig. 6 zeigt die Möglichkeit, mehrere Temperiermodule 1 zusammenzuschließen, wobei die Lüfter 13, 13' z. B. auf einer Seite der zusammengeschlossenen Einheit aus mehreren Temperiermodulen 1 angeordnet sind und eine Strömung durch die in Strömungsrichtung aneinander gereihten Temperiermodule 1 bewirken. Zum möglichst engen Aneinanderkoppeln der Temperiermodule 1 können dabei die Kanalabschnitte 17, 17' der aneinander grenzenden Temperiermodule 1 abgenommen werden. Zur Unterstützung der Luftströmung, insbesondere bei langen Kanälen, können auf der einen Kanalseite blasende, auf der anderen am selben Kanal saugende Lüfter angeordnet sein.

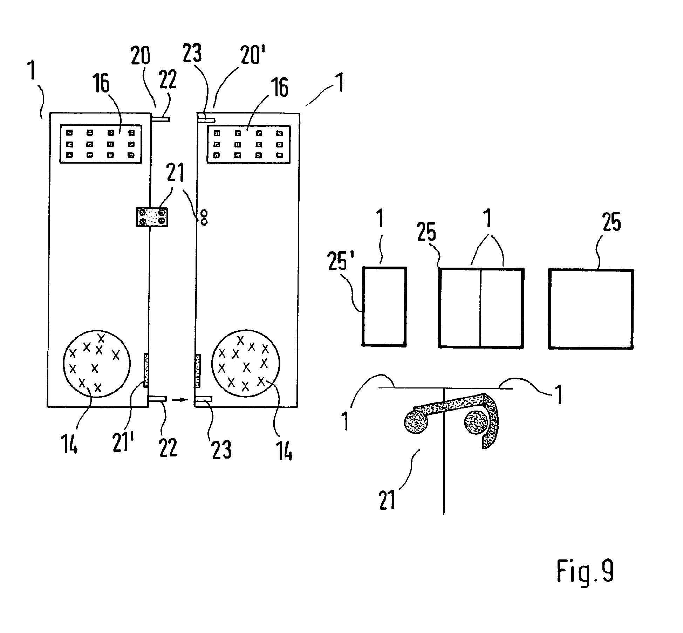

Zum einfachen Herstellen der Koppelverbindung ist an den betreffenden Seiten der Temperiermodule 1 eine Koppelvorrichtung 20, 20' mit mechanischen Koppelmitteln 21, 21' und/oder elektrischen Koppelkomponenten 22, 23 vorgesehen, wobei die mechanischen Koppelmittel 21 und elektrischen Koppelkomponenten 22 an dem einen Temperiermodul 1 komplementär zu den mechanischen Koppelmitteln 21' und elektrischen Koppelkomponenten 23 des anderen Temperiermoduls 1 ausgebildet sind. Auf diese Weise ergibt sich eine sichere mechanische Kopplung bei zuverlässiger elektrischer Verbindung der aneinander gereihten Temperiermodule 1. Die Koppelvorrichtung 20, 20' kann vorteilhaft an einem Trägerabschnitt oder Abschnitt eines Rahmens 25, 25' angebracht sein, wie auch Fig. 9 zeigt. In ähnlicher Weise, wie in Fig. 6 gezeigt, können Koppelvorrichtungen zusätzlich oder ausschließlich auch an den parallel zur Strömungsrichtung verlaufenden Seiten der Temperiermodule ausgebildet sein, womit dann eine Aneinanderreihung senkrecht zur Strömungsrichtung der Temperiermodule 1 ermöglicht wird, d.h. mehrere parallele Kanäle vorhanden sind. Eine einfache Demontage der Kanalabschnitte 17, 17' und/oder der Lüfter 13, 13' trägt dabei zur einfachen Erweiterung bei, wobei die Lüfter wahlweise auch auf entgegen gesetzten Seiten einer aus mehreren Temperiermodulen 1 gebildeten Temperiereinheit angeschlossen werden können, wenn diese in Strömungsrichtung aneinander gereiht sind. Bei einer Aneinanderreihung senkrecht zur Strömungsrichtung können die Lüfter 13, 13' der Temperiermodule 1 an diesen verbleiben und nebeneinander angeordnet werden. Mit der Aneinanderreihung der Temperiermodule ergeben sich vielfältige Möglichkeiten der Anpassung an unterschiedliche Anforderungen an die Temperierleistung, wobei auch nachträgliche einfache Erweiterungsmöglichkeiten beispielsweise bei sich ändernden Anforderungen durch Einbau oder Austausch zu kühlender Komponenten ergeben.

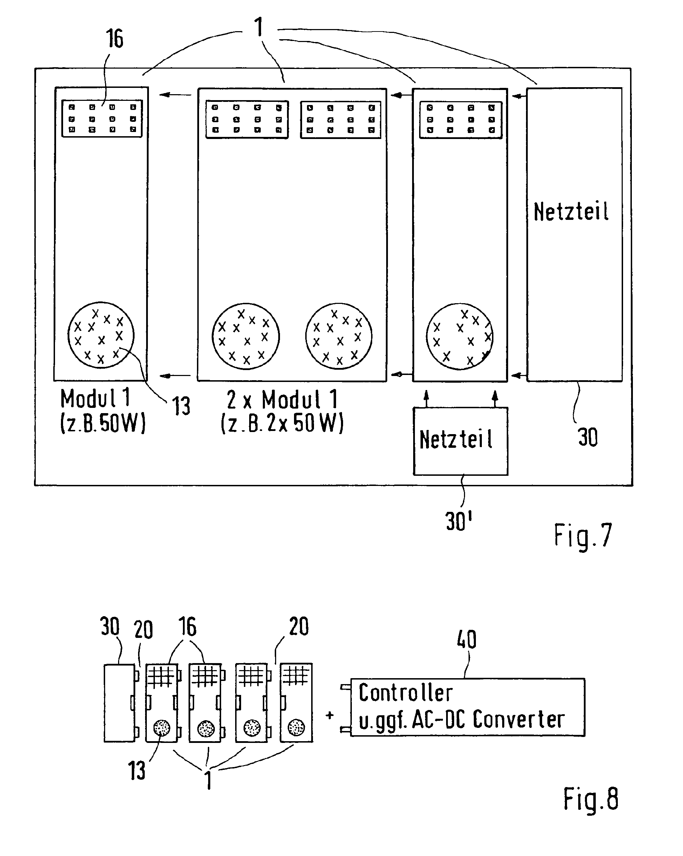

Des Weiteren kann die Temperiervorrichtung mit einem oder mehreren Netzteilen ausgestaltet sein, die in Form von elektrischen Energieversorgungsmodulen 30, 30' einfach an ein Temperiermodul 1 oder eine Gruppe von Temperiermodulen 1 angeschlossen werden können, wie Fig. 7 zeigt. Vorteilhaft sind dabei die Versorgungsmodule 30, 30' ebenfalls mit einer Koppelvorrichtung 20, 20' zur mechanischen und/oder elektrischen Kopplung versehen, wie vorstehend im Zusammenhang mit der Kopplung von Temperiermodulen 1 beschrieben und in Fig. 8 schematisch dargestellt.

Für die Steuerung oder Regelung der Temperierung ist des Weiteren eine Steuereinrichtung 40 vorgesehen. Diese weist vorteilhaft mindestens ein Steuermodul auf, das zur Steuerung unterschiedlich vieler Temperiermodule 1, z. B. auch nur eines Temperierelements ausgebildet ist und auch eine Überwachungseinrichtung für diese aufweisen kann. Die Steuermodule weisen zur einfachen Abstimmung an die jeweiligen Eigenschaften und Anforderungen programmierbare Mikrocontroller auf und können des Weiteren mit AC/DC-Konvertern und weiteren erforderlichen elektrischen Steuerkomponenten versehen sein. Die Steuereinrichtung 40 kann dabei die Temperierleistung z. B. durch unterschiedliche Ansteuerung der Lüfter 13, 13' und/oder der Bestromung der Temperierelemente bis hin zu deren Einschalten oder Abschalten steuern bzw. regeln. Damit ist eine umfangreiche, gezielte Steuerung bzw. Regelung der Temperierung möglich.

Fig. 9 zeigt beispielhaft einige mechanische Koppelmittel 21, 21', wie z. B. eine Schraubverbindung, eine magnetische Verbindung mit an den beiden zusammen zu bringenden Temperiermodulen 1 bzw. Versorgungsmodul 30, 30' oder Steuermodul 40 angeordneten Magnetelementen oder mit einem Schnapphaken. Auch eine schraubenlose Rastverbindung ist möglich. Des Weiteren sind die elektrischen Koppelkomponenten 22, 23 vorteilhaft als Stecker-/Kupplungseinheit ausgebildet. Auch kann ein Rahmen 25 vorgesehen sein, der mehrere zusammengeschlossene Temperiermodule 1 gegebenenfalls im Zusammenschluss mit Versorgungsmodul 30, 30' und/oder Steuermodul 40 umfasst.

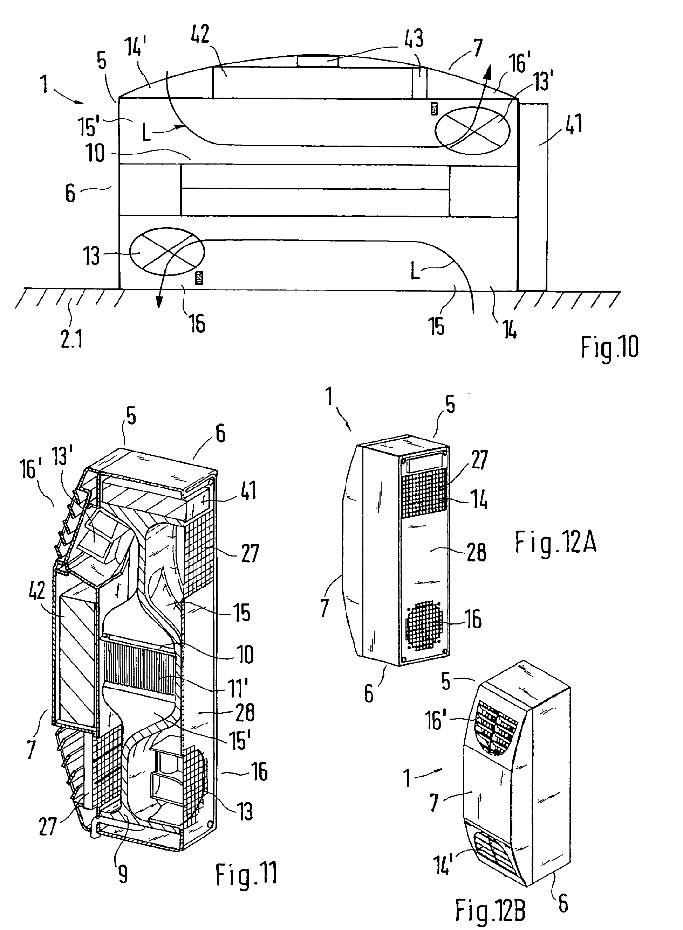

Fig. 10 zeigt ein weiteres Ausführungsbeispiel der Temperiervorrichtung mit einem an einer Gehäusewand, z. B. Rückwand 2.1 außen angebrachten Temperiermodul 1 in schematischer Darstellung im Längsschnitt, wobei im Inneren eines Modulgehäuses 5, nämlich in dessen Gehäuseunterteil 6, eine thermoelektrische Elementanordnung mit z. B. mindestens einem Peltier-Element 10 angeordnet ist, dessen eine (z. B. kühle) Seite zur Rückwand 2.1 hin gekehrt und dessen andere (z. B. warme) Seite von der Rückwand 2.1 weg gekehrt sind. In der Rückwand 2.1 sind entsprechend der Luft-Einströmöffnung 14 und der Luft-Ausströmöffnung 16 des Temperiermoduls 1 positionierte Ausschnitte (oder ein gemeinsamer größerer Ausschnitt) eingebracht, durch den die entlang des Peltier-Elementes 10 strömende Luft aus dem Inneren des Gehäuses 2 eingeführt und anschließend wieder in das Gehäuse gekühlt eingeführt wird, wie die Luftströmung L zeigt, die mittels des in der Nähe der Luft-Ausströmöffnung 16 angeordneten Lüfters 13 erzeugt wird. Die Wärmetauscher auf den beiden Seiten der Peltier-Elemente 10, durch die die Luftströmungen L führen, sind der besseren Übersicht wegen weggelassen. Auch die entlang der von der Rückwand 2.1 abgekehrten Seite des Peltier-Elementes 10 geführte Luftströmung L tritt durch eine betreffende Luft-Einströmöffnung 14' ein und wird über einen Lüfter 13' in der Nähe der Luft-Ausströmöffnung 16' herausgeführt, wobei die Luft-Einströmöffnung 14' und die Luft-Ausströmöffnung 16' in einem nach oben zur Außenseite hin vorstehenden Gehäuseoberteil 7 an dessen beiden Endbereichen ausgebildet sind.

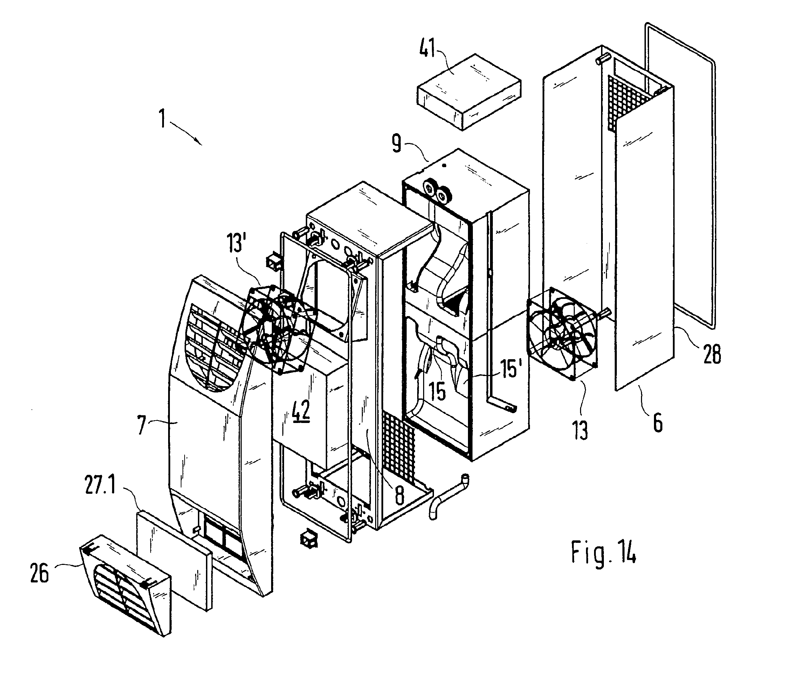

Der mittlere Bereich des von der Rückwand 2.1 weg nach oben gewölbten Gehäuseoberteils überdeckt einen Zwischenraum, der zwischen einer Zwischenwand 8 im oberen Bereich des Gehäuseunterteils 6 und der Innenseite des Gehäuseoberteils 7 ausgebildet ist und ein Netzteil 42 einer Energieversorgung aufnimmt. Außerdem sind in dem Raum zwischen der Zwischenwand 8 und der Deckwand des Gehäuseoberteils 7 optische Anzeigen 43 z. B. mit Leuchtdioden oder steuerbaren alphanumerischen Zeichen angeordnet. Seitlich in dem Gehäuseunterteil 6 zu dessen schmaler Seitenwand hin ist ein Aufnahmeraum gebildet, in den eine Steuereinheit 41 mit einem Mikrocontroller untergebracht ist. Dieser Aufnahmeraum für die Steuereinheit 41 der Steuereinrichtung 40 ist dabei zwischen einem (in Fig. 14 deutlicher gezeigten) Gehäuseeinsatz 9 und der Innenseite der schmalen Seitenwand des Gehäuseunterteils 6 gebildet.

Ein in Fig. 10 schematisch dargestelltes Temperiermodul 1 ist in den Fig. 11 bis 14 in seiner näheren Ausgestaltung wiedergegeben. Wie aus dem in Fig. 11 gezeigten Längsschnitt ersichtlich, sind in dem Gehäuseunterteil 6 die Kühlkanäle 15, 15' in dem Gehäuseeinsatz 9 mittels gekrümmter Kanäle gebildet, die teilweise verengte und teilweise erweiterte Strömungsquerschnitte ergeben, so dass die an den Peltier-Elementen 10, insbesondere den darauf gut wärmeleitend angebrachten Lamellen-Wärmetauschkörpern 11, 11' vorbeiströmende Luft ungehindert strömt und mit hoher Wirksamkeit temperiert wird.

Hierbei sind die Peltier-Elemente 10 in einer oder mehreren Ebenen parallel zu den Seitenwänden des Gehäuseunterteils 6 verlaufenden Ebenen angeordnet, wobei die Lamellen senkrecht zu den Seitenwänden des Gehäuseunterteils 6, und dabei parallel zum Boden 28 des Gehäuseunterteils 6 zum einen auf der warmen Seite und zum anderen auf der kalten Seite der Peltier-Elemente 10 vorstehen. Im Bereich der Peltier-Elemente 10 sind in deren Ebene die dort ebenfalls parallel zu den Seiten des Gehäuseunterteils 6 orientieren Zwischenwände der Kühlkanäle 15, 15' angeordnet, so dass sich im Bereich der Peltier-Elemente 10 eine geschichtete Struktur der Kühlkanäle mit parallel zu den Seitenwänden des Gehäuseunterteils 6 angeordneten Kanalschichten ergibt, wie in Fig. 11 ersichtlich. Dabei sind die Peltier-Elemente im Wesentlichen über die gesamte Höhe des Gehäuseunterteils 6 bzw. des darin eingesetzten Gehäuseeinsatzes 9 im Bereich der Mittelquerebene in Längsrichtung des Modulgehäuses 5 ausgedehnt angeordnet. Sind dabei parallel bezüglich der Seitenwände des Gehäuseunterteils 6 voneinander beabstandete Peltier-Elemente 10 mit physikalisch gleichen Seiten (z. B. warm/warm oder kalt/kalt) einander zugekehrt, so ergibt der Zwischenraum zwischen zwei parallel beabstandeten Peltier-Elementen 10 die betreffende Kanalbreite, wobei die auf den zugekehrten Seiten der Peltier-Elemente 10 angebrachten, mit ihren freien Enden gegeneinander gerichteten Lamellen der Wärmetauschkörper 11 bzw. 11' für einen möglichst effektiven Wärmeaustausch mit der durchströmenden Luft möglichst eng aneinander grenzen. Diese Schichtstruktur der Strömungskanäle 15, 15' braucht nur im Bereich der Peltier-Elemente 10 mit den Wärmetauschkörpern 11, 11' vorhanden zu sein, während sich die Strömungskanäle 15, 15' im Bereich der Luft-Einströmöffnungen 14, 14' und Luft-Ausströmöffnungen 16, 16' über die gesamte Breite des Gehäuseunterteils 6 bzw. des darin eingesetzten Gehäuseeinsatzes 9 erstrecken können und die der Kaltseite zugeordneten (z. B. zum Schaltschrankinneren führenden) und die der Warmseite zugeordneten (z. B. nach außen führenden) Strömungskanäle 15, 15' mit senkrecht zu den Seitenwänden des Gehäuseunterteils 6 verlaufende Wandabschnitte ausgebildet sind.

Fig. 11 zeigt auch die in der Nähe der Luft-Ausströmöffnungen 16, 16' angeordneten Lüfter 13, 13', die bei diesem Ausführungsbeispiel als Axiallüfter ausgebildet sind. Dabei ist in den Gehäuseeinsatz 9 der dem nach außen führenden Strömungskanal 15' zugeordnete Lüfter 13' mit der Lüfterachse schräg zur schmalen Längsseite des quaderförmigen Modulgehäuses 5 ausgerichtet und in einer entsprechend geformten Aufnahme des Gehäuseeinsatzes 9 aufgenommen und darin z. B. mittels Rastens fixiert. Die Ausrichtung der Lüfterachse schräg zu der schmalen Seitenwand (und parallel zu den langen Seitenwänden) ergibt eine Abstimmung auf die Richtung des Luftströmungskanals 15' in diesem Bereich, so dass zumindest eine wesentliche Komponente des Strömungskanals in Richtung der Lüfterachse ausgerichtet ist und eine möglichst gleichmäßige, weitgehend ungehinderte Strömung der Luft mit hohem Luftdurchsatz bei möglichst geringer Lüfterleistung erzielt wird, wodurch der Energiebedarf für die Ansteuerung des Lüfters minimiert und gleichzeitig auch eine möglichst geringe Geräuschentwicklung erreicht wird. Wie Fig. 11 zeigt, ist auch der senkrecht zu den Seitenwänden des Gehäuseunterteils verlaufende Abschnitt schräg bezüglich der schmalen Seitenwand des Modulgehäuses gerichtet und etwa wie die Lüfterachse geneigt. Entsprechend ist auch der lufteinströmseitige Abschnitt des Strömungskanals 15' zur Einströmöffnung 14' hin ausgerichtet.

Ähnlich ist auch der mit dem Gehäuse- bzw. Schaltschrankinnern in Verbindung stehende Strömungskanal 15 geformt, wobei jedoch der Bezug zum Innenraum des Schaltschranks 2 bzw. Gehäuses berücksichtigt ist. Der im Bereich der Luft-Ausströmöffnung 16 des Strömungskanals 15 angeordnete Lüfter ist wegen der flachen Bodenseite des Gehäuseunterteils 6 bzw. des Gehäuseeinsatzes 9 allerdings mit seiner Achse aus Einbaugründen senkrecht zum Boden 28 des Gehäuseunterteils 6 angeordnet, wobei sich aber auch für den Strömungskanal 15 im Ausströmbereich durch eine schräg zur Schmalseite des Gehäuseunterteils 6 gerichtete Kanalwand des Strömungskanals 15 eine wesentliche Strömungskomponente in Richtung der Lüfterachse ergibt und auch dabei eine hohe Luftströmung bei relativ geringem elektrischem Leistungsbedarf des Lüfters 13 erreicht wird. Der Aufbau der Strömungskanäle 15, 15' mit erweitertem Bereich in der Umgebung der Peltier-Elemente 10 und verengten Bereichen vorher und anschließend ergibt eine effiziente Temperierung bei kompaktem Aufbau durch Umlenkung der Strömung.

Wie die Fig. 11 bis 14 weiter zeigen, sind die Luft-Einströmöffnungen 14, 14' sowie die Luft-Ausströmöffnungen 16, 16' mit jeweiligen Lüftungsgittern 27 ausgestattet, um gröbere Fremdkörper von dem Strömungsweg abzuhalten. Soweit unter bestimmten Einsatzbedingungen erforderlich, können zusätzlich auch noch mehr oder weniger grobe Filtermatten insbesondere im Bereich der Lüftungsgitter 27 eingesetzt werden. Im Bereich des haubenartigen Gehäuseoberteils 7 können die Lüftungsgitter 27 gegebenenfalls in Kombination mit Lüftermatten in getrennt herausnehmbaren, eingerasteten Einsätzen 26 angeordnet sein, so dass sie leicht austauschbar sind. Das in Längsschnitt im Wesentlichen trapezförmige oder alternativ konvex nach außen gewölbte Gehäuseoberteil 7 weist dabei die Einsätze 26 in den beiden seitlichen Endbereichen auf, die bei Trapezform die schrägen Seitenflächen bilden, in denen auch die betreffende Luft-Einströmöffnung 14' bzw. Ausströmöffnung 16' gegebenenfalls mit dem zugeordneten Lüfter 13' angeordnet sind.

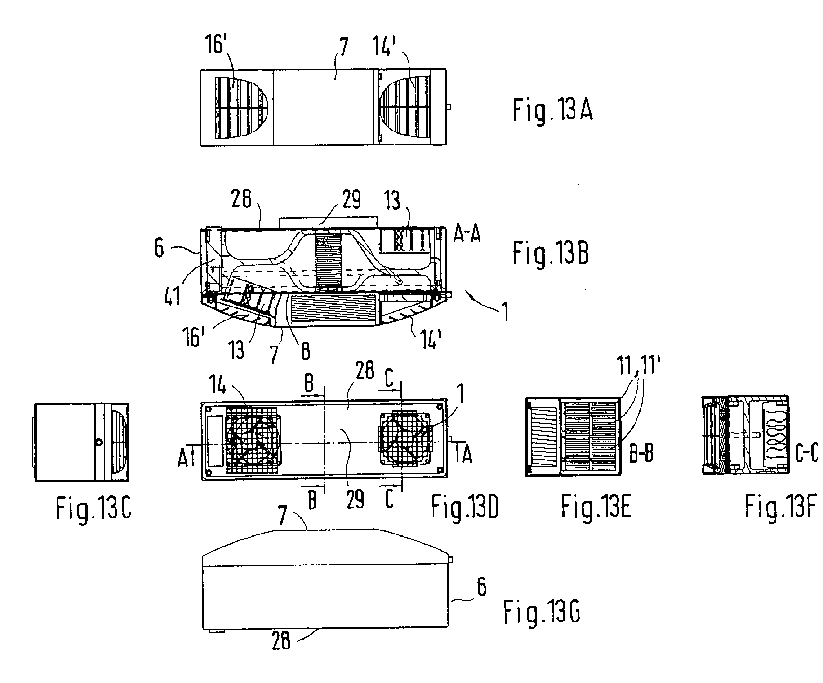

Die genannte Ausbildung des Modulgehäuses 5 mit Gehäuseunterteil 6, Gehäuseoberteil 7, Zwischenwand 8, Lüftern 13, 13' und Ausbildung der Strömungskanäle 15, 15' sowie Luft-Einströmöffnungen 14, 14' und Luft-Ausströmöffnungen 16, 16' sind auch in den Ansichten nach Fig. 13A bis 13G ersichtlich.

Der Aufbau des Modulgehäuses 5 mit Gehäuseunterteil 6, Gehäuseoberteil 7 und Gehäuseeinsatz 9 mit den zugeordneten Lüftern 13, 13' ist im Einzelnen in Fig. 14 dargestellt, wobei auch der Einsatz der Lüfter 13, 13', die Luft-Einströmöffnungen 14, 14' und Luft-Ausströmöffnungen 16, 16' mit jeweiligen Lüftungsgittern 27 und gegebenenfalls Lüftermatten 27.1 sowie die Einsätze 26 des Gehäuseoberteils 7 dargestellt sind. Ersichtlich ist auch die bezüglich der Seitenwand des Gehäuseunterteils 6 in dem Gehäuseeinsatz 9 vorgesehene geschichtete Anordnung der Strömungskanäle 15, 15', wobei der Strömungskanal 15 in Querrichtung im mittleren Bereich und zwei Abschnitte des Strömungskanals 15' (entsprechend den zugeordneten Außenseiten der Peltier-Elemente 10) in den seitlich angrenzenden Bereichen angeordnet sind. Ferner sind zwischen den wesentlichen Komponenten des Gehäuseunterteils 6 und dem Gehäuseoberteil 7 Dichtungselemente angeordnet. Der Gehäuseeinsatz 9 ist vorteilhaft aus temperaturbeständigem Kunststoff hergestellt, während das Gehäuseunterteil 6 z. B. aus Metall und das Gehäuseoberteil 9 ebenfalls aus Kunststoff hergestellt sind. Das Gehäuseunterteil 6 weist einen im Querschnitt U-förmigen unteren Abschnitt mit Boden 28 und Seitenwänden auf, während ein oberer Abschnitt des Gehäuseunterteils 6 die Zwischenwand 8 mit entsprechenden Ausschnitten für die Luft-Einströmöffnung 14' und Luft-Ausströmöffnung 16' sowie zwei schmale Seitenwände des quaderförmigen Gehäuseunterteils 6 aufweist.

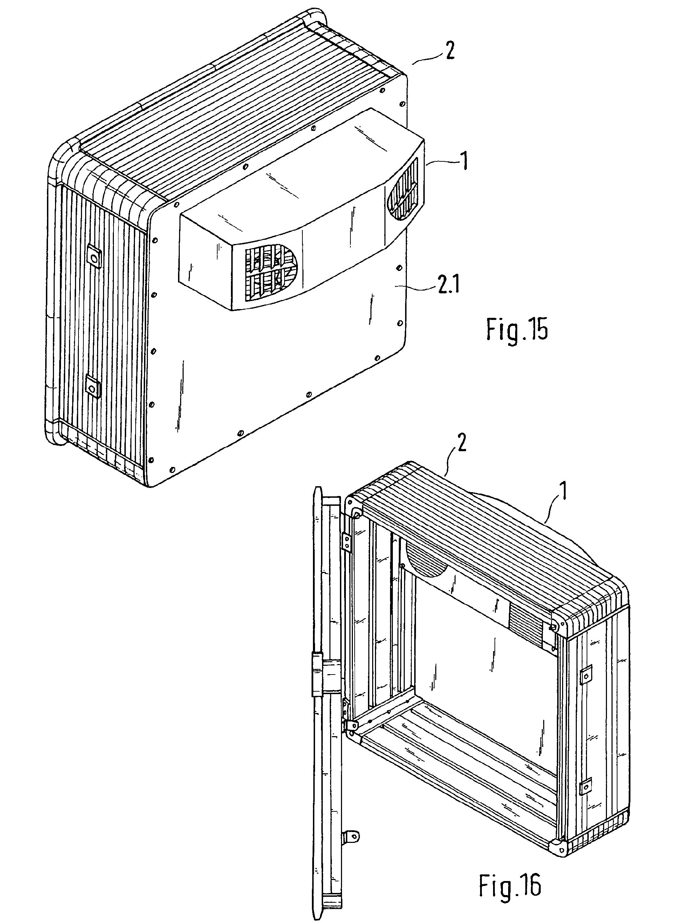

Wie aus Fig. 15 ersichtlich, kann ein Temperiermodul 1 mit seinem Boden 28 unmittelbar auf der Außenseite, z. B. Rückwand 2.1 des Gehäuses 2 aufgebracht sein, wobei in der Rückwand 2.1 der Luft-Einströmöffnung 14 und Luft-Ausströmöffnung 16 entsprechende Ausschnitte eingebracht sind. Bei dieser Ausführung ist der Innenraum des Gehäuses 2 für Einbauten weitgehend vollständig verfügbar, wie auch Fig. 16 zeigt.

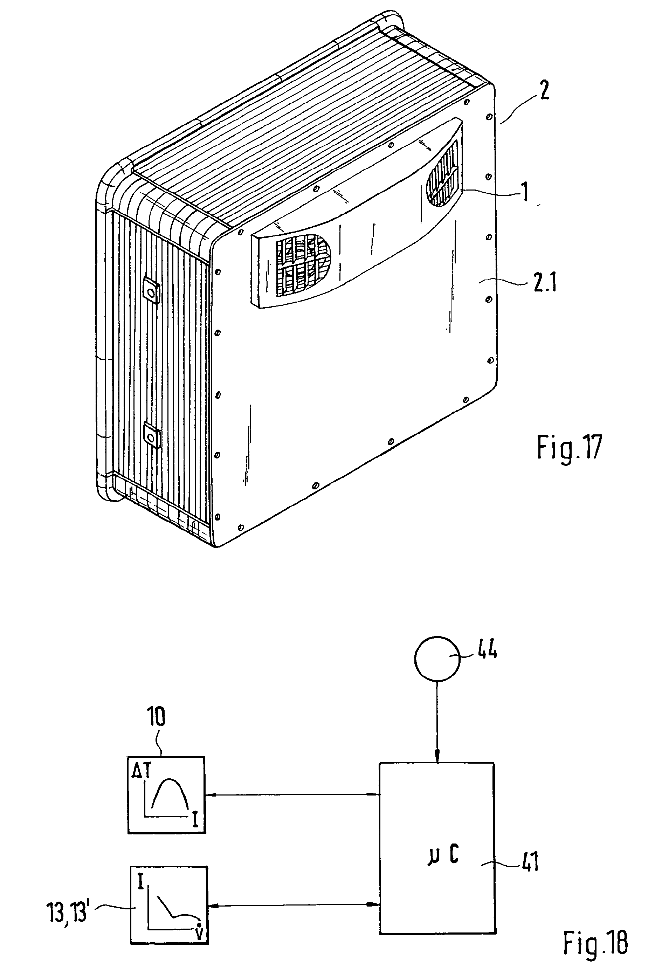

Bei dem Ausführungsbeispiel nach Fig. 17 dagegen ist das Temperiermodul 1 bis auf das Gehäuseoberteil 7 in eine entsprechend ausgebildete Aussparung in der Rückwand 2.1 von der Außenseite her in den Innenraum des Gehäuses 2 eingesetzt. Somit eignen sich auch die Temperiervorrichtungen gemäß den Ausführungsbeispielen nach den Fig. 10 bis 17 für einen Aufbau auf oder einen Einbau in Gehäusen bzw. Schaltschränken. Dabei können mehrere derartige Lüfter parallel mit ihren Längsseiten nebeneinander angeordnet werden, um unterschiedliche Temperierleistungen zu erhalten.

Fig. 18 zeigt ein Ausführungsbeispiel für die Steuereinrichtung 40 eines Temperiermoduls 1 oder einer Zusammenschaltung mehrerer Temperiermodule. Die Steuereinrichtung kann z. B. eine in der vorstehend beschriebenen Weise ausgebildete, zwischen der Innenseite des Gehäuseoberteils 7 und der Oberseite der Zwischenwand 8 angeordnete Steuereinheit und/oder eine zwischen der Schmalseite des Gehäuseeinsatzes 9 und der Schmalseite des Gehäuseunterteils 6 angeordnete Steuereinheit 41 aufweisen, wobei die Steuereinheit 41 vorteilhaft einen programmierbaren Mikrocontroller besitzt. In dem Mikrocontroller ist ein Programm für die Steuerung des Temperiermoduls 1 mit Ansteuerung für die Lüfter 13, 13' und die Peltier-Elemente 10 hinterlegt. Die Ansteuerung erfolgt in Abhängigkeit von Sensorsignalen, die von einer Sensoranordnung 44 geliefert werden, insbesondere Temperatursignalen, Feuchte, Volumen des zu kühlenden Raumes und dgl. Außerdem können in einem Speicher der Steuereinheit 41 bzw. dem entsprechend ausgebildeten Mikrocontroller 41 Tabellen mit Einstellparametern hinterlegt sein, die in dem Programm nach vorgegebenen Kriterien verrechnet werden. Die elektrische Energieversorgung der Lüfter 13, 13' und Peltier-Elemente 10 erfolgt vorzugsweise mittels des Netzteils 42, das in dem Aufnahmeraum zwischen dem Gehäuseoberteil 7 und der Zwischenwand 8 angeordnet ist. Dabei wird in der Regel eine bestimmte Versorgungsspannung von z. B. 24V vorgegeben, während die erforderliche Temperierleistung, Kälteoder Wärmeleistung, durch optimierte Ansteuerung der Peltier-Elemente 10 und Lüfter 13, 13' auch in Abhängigkeit von den Umgebungsparametem bzw. Sensorsignalen möglichst energieeffizient gesteuert bzw. geregelt wird. Hierzu werden in der Steuereinheit die Ansteuercharakteristiken der Lüfter 13, 13' und der PeltierElemente 10 miteinander in Beziehung gesetzt und eine Energie optimierte Ansteuerung dieser Elemente gewählt. Dabei wird zugrundegelegt, dass die Peltier-Elemente 10 in einem bestimmten Strom-Ansteuerbereich eine maximale Temperaturdifferenz zwischen Warm- und Kaltseite ermöglichen und dass die Lüfter so ausgelegt sind, dass der Volumenstrom der Lüfter in Abhängigkeit des elektrischen Stroms ein Optimum ergibt in Abstimmung auf die Charakteristik der Peltier-Elemente und die darauf abgestimmte Geometrie der Strömungskanäle.

## Patentansprüche

1. Thermoelektrische Temperiervorrichtung mit mehreren thermoelektrisch arbeitenden Temperierelementen (10) mit einer sich bei Zuführung elektrischen Stroms bildenden kalten Fläche auf ihrer einen Seite und einer warmen Fläche auf ihrer gegenüberliegenden Seite, mit auf beiden Seiten aufgebrachten, in einer jeweiligen Luftströmungskammer untergebrachten Luft-Wärmetauscherkörpern (11, 11') und mit eine Luftströmung entlang denselben bewirkenden Lüftern (13, 13'), wobei eine als Temperiermodul (1) ausgestaltete Einheit der Temperiervorrichtung, das in einem Gehäuse (5) mit Gehäuseunterteil (6) und Gehäuseoberteil (7) untergebracht ist, in der Weise aufgebaut ist, dass die Luftströmungskammern als die Wärmetauschkörper (11, 11') in Strömungsrichtung seitlich und auf deren von den Temperierelementen (10) abgewandter Seite umgebende Strömungskanäle (15, 15') ausgebildet sind, die eine Luft-Einströmöffnung (14, 14') und eine Luft-Ausströmöffnung (16, 16') aufweisen, wobei der Lüfter (13, 13') des jeweiligen Strömungskanals (15, 15') an dessen Einströmöff nung (14, 14') oder an dessen Ausströmöffnung (16, 16') angeordnet ist, wobei die Temperierelemente (10), die Wärmetauschkörper (11, 11') und die Lüfter (13, 13') in dem Gehäuseunterteil (6) angeordnet und gehalten sind und auch die Strömungskanäle (15, 15') in dem Gehäuseunterteil (6) angeordnet sind,
dadurch gekenntzeichnet, dass
das Gehäuseunterteil (6) mit einem auf seiner Unterseite abnehmbar angebrachten Gehäuseboden (28) versehen und auf seiner gegenüberliegenden Oberseite mit dem Gehäuseoberteil (7) abgedeckt ist, dass in dem Gehäuseboden (28) eine Einströmöffnung (14) und eine mit dieser über einen Strömungskanal (15) in Strömungsverbindung stehende Ausströmöffnung (16) angeordnet sind und dass in dem Gehäuseoberteil (7) eine weitere Einströmöffnung (14') und eine mit dieser über einen anderen Strömungskanal (15') in Verbindung stehende weitere Ausströmöffnung (16') angeordnet sind, wobei die Strömungskanäle mittels gekrümmter Kanäle gebildet sind, die teilweise verengte und teilweise erweiterte Querschnitte ergeben, wobei ein erweiterter Querschnitt in der Umgebung der thermoelektrisch arbeitenden Temperierelemente (10) und verengte Querschnitte vorher und anschließend angeordnet sind.

2. Temperiervorrichtung nach Anspruch 1 , **dadurch gekennzeichnet, dass** die Lüfter (13, 13') seitlich neben dem betreffenden Wärmetauschkörper (11, 11') beide auf der gleichen Seite oder auf gegenüberliegenden Seiten des Temperiermoduls (1) integriert sind.

3. Temperiervorrichtung nach einem der vorhergehenden Ansprüche, **dadurch gekennzeichnet, dass** die Lüfter (13, 13') beide als Radiallüfter ausgebildet sind, deren radial- seitige Strömungsöffnung dem jeweiligen Wärmetauschkörper (11, 11') zugekehrt ist und deren axialseitige Strömungsöffnung senkrecht zur Flachseite der Temperierelemente (10) gerichtet ist, oder dass die Lüfter (13, 13') als Axiallüfter ausgebildet sind und der jeweilige Strömungskanal (15, 15') in seinem dem betreffenden Axiallüfter zugekehrten Bereich eine in der Achsenrichtung des Radiallüfters zeigende Richtungskomponente aufweist.

4. Temperiervorrichtung nach einem der vorhergehenden Ansprüche, **dadurch gekennzeichnet, dass** beide Lüfter (13, 13') als blasende, beide als saugende oder einer als saugender und der andere als blasender Lüfter bezüglich des zugehörigen Strömungskanals (15, 15') ausgebildet sind.

5. Temperiervorrichtung nach einem der vorhergehenden Ansprüche, **dadurch gekennzeichnet, dass** der der kalten Fläche zugeordnete Strömungskanal (11 oder 11') einerseits und der der warmen Fläche zugeordnete Strömungskanal (11' oder 11) andererseits im Gegenstrom oder im Gleichstrom von der Luft durchströmt werden.

6. Temperiervorrichtung nach einem der vorhergehenden Ansprüche, **dadurch gekennzeichnet, dass** ein Temperiermodul (1) an mindestens einem Randabschnitt im Bereich des Umfangsrandes mit einer Koppelvorrichtung (20) versehen ist, über die ein entsprechend ausgebildetes, eine komplementäre Koppelvorrichtung (20') aufweisendes weiteres Temperiermodule (1) anschließbar ist.

7. Temperiervorrichtung nach Anspruch 1, **dadurch gekennzeichnet, dass** jedes Temperiermodule (1) an einem Randabschnitt eine Koppelvorrichtung (20) und an einem anderen Randabschnitt eine komplementäre Koppelvorrichtung (20') aufweist.

8. Temperiervorrichtung nach einem der vorhergehenden Ansprüche, **dadurch gekennzeichnet, dass** die Koppelvorrichtung (20) mechanische Koppelmittel (21, 21') und elektrische Koppelkomponenten (22, 23) aufweist.

9. Temperiervorrichtung nach Anspruch 8, **dadurch gekennzeichnet, dass** die elektrischen Koppelkomponenten (22, 23) mindestens eine Stecker- /Kupplungseinheit für die elektrische Kopplung von Signalleitungen und/oder Versorgungsleitungen aufweisen.

10. Temperiervorrichtung nach Anspruch 8 oder 9, **dadurch gekennzeichnet, dass** die mechanischen Koppelmittel (21, 21') Steck-, Rast-, Schraub- und/oder Magnetverbindungselemente aufweisen.

11. Temperiervorrichtung nach einem der vorhergehenden Ansprüche, **dadurch gekennzeichnet, dass** eine Steuereinrichtung vorhanden ist, die mit einem oder einer Gruppe von Temperiermodulen (1) in elektrische Verbindung gebracht oder bringbar ist und die so ausgebildet ist, dass ein Temperiermodul (1) und/oder mehrere Temperiermodule (1) im Verbund mit unterschiedlicher Temperierleistung steuerbar oder regelbar sind.

12. Temperiervorrichtung nach Anspruch 11, **dadurch gekennzeichnet, dass** die Steuereinrichtung so ausgebildet ist, dass unterschiedliche Temperierleistung durch unterschiedliche Ansteuerung der Lüfter (13, 13') und/oder durch unterschiedliche Steuerung der Stromzuführung zu den Temperierelementen (10) steuerbar oder einregelbar sind.

13. Temperiervorrichtung nach Anspruch 12 oder 13, **dadurch gekennzeichnet, dass** die Temperiermodulen (1) mittels der Steuereinrichtung untereinander unterschiedlich steuerbar sind.

14. Temperiervorrichtung nach einem der Ansprüche 11 bis 13, **dadurch gekennzeichnet, dass** die Steuereinrichtung zum Ansteuern der Lüfter (13, 13') mit unterschiedlicher elektrischer Leistung und zum Ansteuern der Temperierelemente (10) mit unterschiedlicher elektrischer Leistung ausgebildet ist, um einen unterschiedlichen Temperierleistungsbedarf abzudecken, und dass die Ansteuerung der Lüfter (13, 13') und die Ansteuerung der Temperierelemente (10) in der Weise aufeinander abgestimmt sind, dass der Gesamt- bedarf an elektrischer Leistung für die Ansteuerung der Lüfter (13, 13') und der Temperierelemente (10) bei der jeweiligen Temperierleistung minimal ist.

15. Temperiervorrichtung nach einem der Ansprüche 11 bis 14, **dadurch gekennzeichnet, dass** die Steuereinrichtung mindestens eine als Mikrokontroller ausgebildete Steuereinheit (41) aufweist, in der Programme zum Bereitstellen der Signale für die Ansteuerung der Lüfter (13, 13') und der Temperierelemente (10) in Abhängigkeit von den Temperierleistungsbedarf vermittelnden Sensorsignalen hinterlegt sind.

16. Temperiervorrichtung nach einem der vorhergehenden Ansprüche, **dadurch gekennzeichnet, dass** eine elektrische Energieversorgung mit mindestens einem Energieversorgungsmodul (30, 30') vorhanden ist, das oder die zur wahlweisen Versorgung eines einzelnen Temperiermoduls (1) oder einer Gruppe von Temperiermodulen (1) ausgebildet ist/sind.

17. Temperiervorrichtung nach einem der Ansprüche 11 bis 16, **dadurch gekennzeichnet, dass** die Steuereinrichtung mindestens ein Steuermodul (40) mit eigenem Gehäuse aufweist und dass das Steuermodul (40) und/oder das oder die Energieversorgungsmodule (30, 30') ebenfalls mit einer Koppelvorrichtung (20) zur elektrischen und/oder mechanischen Kopplung mit einem oder mehreren Temperiermodulen (1) versehen ist/sind.

18. Temperiervorrichtung einem der vorhergehenden Ansprüche, **dadurch gekennzeichnet, dass** das Gehäuseoberteil (7) nach außen auf der Oberseite haubenartig vorsteht und im Längsschnitt trapezförmig oder nach außen konvex gewölbt geformt ist und dass zwischen einem mittleren Abschnitt des Gehäuseoberteils (7) und einer Zwischenwand (8) am zugekehrten oberen Bereich des Gehäuseunterteils eine Aufnahmekammer gebildet ist, in der eine elektrische Energieversorgung, insbesondere ein Netzteil (42), untergebracht ist.

19. Temperiervorrichtung nach einem der vorhergehenden Ansprüche, **dadurch gekennzeichnet, dass** in dem Gehäuseunterteil (7) ein in seinen Außenkonturen quaderförmiger Gehäuseeinsatz (9) eingesetzt ist, in dem die Strömungskanäle (15, 15') ausgebildet sind.

20. Temperiervorrichtung nach Anspruch 19, **dadurch gekennzeichnet, dass** der Gehäuseeinsatz (9) gegenüber dem Gehäuseunterteil (7) in seiner Längsrichtung verkürzt ist und dass in dem Raum zwischen einer schmalen Außenseite des Gehäuseeinsatzes (9) und der zugewandten schmalen Innenseite des Gehäuseunterteils (7) die Steuereinheit (41) aufgenommen ist.

21. Temperiervorrichtung nach einem der vorhergehenden Ansprüche, **dadurch gekennzeichnet, dass** in einer oberen Deckwand des Gehäuseoberteils (7) eine optische Anzeigevorrichtung eingebaut ist.

## Claims

1. A thermoelectric tempering device with a plurality of thermoelectrically operating tempering elements (10) with a cold surface formed upon the supply of electrical current on its one side, and a warm surface on its opposite side, with air and heat exchange bodies (11, 11') attached in a respective air flow chamber, and with ventilators having the same effect on an air flow (13, 13'), whereby a unit fashioned as a tempering module (1), which is set up in a housing (5) with a housing under part (6) and a housing upper part (7), is constructed in such a way that the air flow chambers are arranged so that the heat exchange bodies (11, 11') are configured on the one side in the direction of the flow and on the side facing away from the tempering elements (10) on the surrounding flow channels (15, 15'), which have an air intake opening (14, 14') and a discharge opening (16, 16'), whereby the ventilators (13, 13') of the particular flow channel (15, 15') are set up on their intake opening (14, 14') or their discharge opening (16, 16'), wherein the tempering elements (10), the heat exchange bodies (11, 11'), and the ventilators (13, 13') are arranged and fastened in the housing under part and the flow channels (15, 15') are arranged in the housing under part (6),
so **characterized in that**
the housing under part (6) is provided with a housing floor (28) that is attached and is removable on its under side, and is covered on its opposite upper side with the housing upper part (7), that in the housing floor (28) an intake opening (14) and a discharge opening (16) are arranged standing in flow connection with it via a flow channel (15), and that in the housing upper part (7) another intake opening (14') and another discharge opening (16') are arranged standing in connection with it via another flow channel (15'), whereby the flow channels are set up using bent channels, which give partially narrowed and partially widened cross-sections, wherein a widened cross-section in the area of the tempering elements (10) and narrowed cross-sections that function thermoelectrically is previously and afterwards arranged.

2. Tempering device according to claim 1, so **characterized in that** the ventilators (13, 13') are integrated on the side next to the particular heat exchange bodies (11, 11'), both on the same side or on the opposite sides of the tempering module (1).

3. Tempering device according to one of the prior claims, so **characterized in that** the ventilators (13, 13') are both configured as radial ventilators, whose radial side stream opening is turned to the particular heat exchange body (11, 11'), and whose axial side stream opening is directed perpendicular to the flat side of the tempering elements (10), or that the ventilators (13, 13') are configured as axial ventilators, and the particular flow channel (15, 15') has in its area turned toward the particular axial ventilator an indicating direction component in the axis direction of the radial ventilator.

4. Tempering device according to one of the prior claims, so **characterized in that** both ventilators (13, 13') are configured as blowers, both are configured as suction devices, or one is configured as a suction ventilator and the other as a blowing ventilator with regard to the particular flow channel (15, 15').

5. Tempering device according to one of the prior claims, so **characterized in that** the flow channel (11 or 11') oriented to the cold surface on one side and the flow channel (11' or 11) oriented to the warm surface on the other side are followed through by the air in a counter current or in a direct current.

6. Tempering device according to one of the prior claims so **characterized in that** a tempering module (1) is provided on at least one marginal section in an area of the marginal range with a coupling device (20), by which a corresponding configured tempering module (1) is connectable with a complementary coupling device (20') having another tempering module (1).

7. Tempering device according to claim 1, so **characterized in that** each tempering module (1) has a coupling device (20) on one marginal section and a complementary coupling device (20') on another marginal section.

8. Tempering device according to one of the prior claims, so **characterized in that** the coupling device (20) has mechanical coupling means (21, 21') and electrical coupling components (22, 23) .

9. Coupling device according to claim 8, so **characterized in that** the electrical coupling components (22, 23) have at least one plug or coupling unit for the electrical coupling of the signal lines and/or supply lines.

10. Tempering device according to claim 8 or 9, so **characterized in that** the mechanical coupling means (21, 21') have connecting elements that are insertable, latchable, screwable, and/or magnetic.

11. Tempering device according to one of the prior claims, so **characterized in that** a control device exists that is attached or can be attached with an electrical connection to one or a group of tempering modules (1), and that is so configured that a tempering module (1) and/or several tempering modules (1) can be controlled or regulated in connection with various tempering output.

12. Tempering device according to claim 11, so **characterized in that** the control adjuster is so configured that various tempering outputs can be controlled or can be regulated by variable adjustment of the flow direction to the tempering elements (10).

13. Tempering device according to claim 12 or 13, so **characterized in that** the tempering modules (1) can be controlled differently from one another using the control adjuster.

14. Tempering device according to one of claims 11 to 13, so **characterized in that** the control adjuster for adjusting the ventilators (13, 13') is configured with variable electrical output and is configured with variable electrical output for adjusting the tempering elements (10), in order to cover various means for variable tempering output, and that the adjustment of the ventilators (13, 13') and the adjustment of the tempering elements (10) agree with one another in a way that the total need for electrical output is minimal for the adjustment of the ventilators (13, 13') and the tempering elements (10) for the particular tempering output.

15. Tempering device according to one of claims 11 to 14, so **characterized in that** the control adjuster has at least one control unit (41) configured as a microcontroller, in which programs are located for preparing signals for the adjustment of the ventilators (13, 13') and the tempering elements (10), as a function of the sensor signals communicating the need for tempering output.

16. Tempering device according to one of the prior claims, so **characterized in that** an electrical supply of energy is available with at least one energy supply module (30, 30'), which is or are configured for selectable supply of an individual tempering module (1) or a group of tempering modules (1).

17. Tempering device according to one of claims 11 to 16, so **characterized in that** the control adjuster has at least one control module (40) with its own housing, and that the control module (40) and/or the energy supply modules (30, 30') is/are provided also with a coupling device (20) for electrical and/or mechanical coupling with one or several tempering modules (1).

18. Tempering device according to one of the prior claims, so **characterized in that** the housing upper part (7) protrudes to the outside on the upper side in a dome shape, and is formed in the longitudinal section like a trapezoid or is vaulted to the outside in convex form, and that a reception chamber is set up between a central section of the housing upper part (7) and an intermediate wall (8) on the facing upper area of the housing under part, in which an electrical energy supply, in particular a network part (42), is attached.

19. Tempering device according to one of the prior claims so **characterized in that** a outwardly contoured cuboid housing insert (9) is inserted into the housing under part (7), in which the stream channels (15, 15') are configured.

20. Tempering device according to claim 19, so **characterized in that** the housing insert (9) is shortened in its longitudinal direction opposite the housing under part (7), and that the control unit (41) is housed in the space between a narrow outside of the housing insert (9) and the narrow inner side of the housing under part (7) turned toward it.

21. Tempering device according to one of the prior claims, so **characterized in that** an optical display device is built into an upper covering wall of the housing upper part (7).

## Revendications

1. Dispositif d'équilibrage de température thermoélectrique équipé de plusieurs éléments régulateurs de température à fonctionnement thermoélectrique (10) comprenant sur un de leurs côtés une surface froide qui se forme lors de l'application d'un courant électrique et une surface chaude sur leur côté opposé, des corps d'échange aérothermique (11, 11') disposés sur les deux côtés et montés dans une chambre d'écoulement d'air respective, et des ventilateurs (13, 13') qui produisent un écoulement d'air le long desdits éléments, une unité du dispositif d'équilibrage de température, réalisée sous la forme d'un module d'équilibrage de température (1) monté dans un boîtier (5) comprenant une partie inférieure de boîtier (6) et une partie supérieure de boîtier (7), étant configurée de telle sorte que les chambres d'écoulement d'air sont réalisées sous la forme de conduits d'écoulement (15, 15') qui entourent les corps d'échange thermique (11, 11') latéralement dans le sens d'écoulement et sur leur côté à l'opposé des éléments régulateurs de température (10) et qui possèdent un orifice d'entrée d'air (14, 14') et un orifice de sortie d'air (16, 16'), le ventilateur (13, 13') du conduit d'écoulement (15, 15') respectif étant disposé au niveau de son orifice d'entrée (14, 14') ou de son orifice de sortie (16, 16'), les éléments régulateurs de température (10), les corps d'échange thermique (11, 11') et les ventilateurs (13, 13') étant disposés et maintenus dans la partie inférieure de boîtier (6) et les conduits d'écoulement (15, 15') étant disposés également dans la partie inférieure de boîtier (6),
**caractérisé en ce que** la partie inférieure de boîtier (6) est pourvue d'un fond de boîtier (28) monté de manière amovible sur sa face inférieure et recouvert sur sa face supérieure opposée par la partie supérieure de boîtier (7), **en ce qu'**un orifice d'entrée (14) et un orifice de sortie (16) en liaison fluidique avec celui-ci par le biais d'un conduit d'écoulement (15) sont disposés dans le fond de boîtier (28), et **en ce qu'**un autre orifice d'entrée (14') et un autre orifice de sortie (16') en liaison fluidique avec celui-ci par le biais d'un autre conduit d'écoulement (15') sont disposés dans la partie supérieure de boîtier (7), les conduits d'écoulement étant formés par des conduits coudés donnant des sections transversales pour partie rétrécies et pour partie élargies, une section transversale élargie étant disposée au voisinage des éléments régulateurs de température à fonctionnement thermoélectrique (10) et des sections transversales rétrécies étant disposées avant et après lesdits éléments.

2. Dispositif d'équilibrage de température selon la revendication 1, **caractérisé en ce que** les ventilateurs (13, 13') sont intégrés latéralement à côté du corps d'échange thermique (11, 11') concernés, soit les deux du même côté, soit sur des côtés opposés du module d'équilibrage de température (1).

3. Dispositif d'équilibrage de température selon l'une des revendications précédentes, **caractérisé en ce que** les ventilateurs (13, 13') sont réalisés les deux sous la forme de ventilateurs radiaux dont l'orifice d'écoulement côté radial est tourné vers le corps d'échange thermique (11, 11') respectif et dont l'orifice d'écoulement côté axial est orienté perpendiculairement au côté plat des éléments régulateurs de température (10), ou **en ce que** les ventilateurs (13, 13') sont réalisés sous la forme de ventilateurs axiaux et le conduit d'écoulement (15, 15') respectif présente une composante directionnelle orientée dans le sens de l'axe du ventilateur radial dans sa zone tournée vers le ventilateur axial concerné.

4. Dispositif d'équilibrage de température selon l'une des revendications précédentes, **caractérisé en ce que** les ventilateurs (13, 13') sont réalisés les deux sous la forme de ventilateurs soufflants, les deux sous la forme de ventilateurs aspirants, ou un sous la forme de ventilateur aspirant et l'autre sous la forme de ventilateur soufflant par rapport au conduit d'écoulement (15, 15') associé.

5. Dispositif d'équilibrage de température selon l'une des revendications précédentes, **caractérisé en ce que** le conduit d'écoulement (11 ou 11') affecté à la surface froide d'une part et le conduit d'écoulement (11' ou 11) affecté à la surface chaude d'autre part sont parcourus par l'air à contre-courant ou à co-courant.

6. Dispositif d'équilibrage de température selon l'une des revendications précédentes, **caractérisé en ce qu'**un module d'équilibrage de température (1) sur au moins une partie de bord dans la zone du bord périphérique d'un dispositif d'accouplement (20) au moyen duquel un autre module d'équilibrage de température (1) configuré en conséquence et comportant un dispositif d'accouplement complémentaire (20') peut être raccordé.

7. Dispositif d'équilibrage de température selon la revendication 1, **caractérisé en ce que** chaque module d'équilibrage de température (1) comporte un dispositif d'accouplement (20) sur une partie de bord et un dispositif d'accouplement complémentaire (20') sur une autre partie de bord.

8. Dispositif d'équilibrage de température selon l'une des revendications précédentes, **caractérisé en ce que** le dispositif d'accouplement (20) comporte des moyens d'accouplement mécaniques (21, 21') et des composants d'accouplement électriques (22, 23).

9. Dispositif d'équilibrage de température selon la revendication 8, **caractérisé en ce que** les composants d'accouplement électriques (22, 23) comportent au moins un ensemble connecteur / prise pour le couplage électrique de câbles de signal et/ou de câbles d'alimentation.

10. Dispositif d'équilibrage de température selon la revendication 8 ou la revendication 9, **caractérisé en ce que** les moyens d'accouplement mécaniques (21, 21') comprennent des éléments de liaison à embrochage, à encliquetage, à vis et/ou magnétiques.

11. Dispositif d'équilibrage de température selon l'une des revendications précédentes, **caractérisé en ce qu'**il est prévu un système de commande qui est ou peut être mis en liaison électrique avec un ou un groupe de modules d'équilibrage de température (1) et qui est configuré de façon à pouvoir commander ou réguler un module d'équilibrage de température (1) et/ou plusieurs modules d'équilibrage de température (1) en parallèle avec une puissance d'équilibrage de température variable.

12. Dispositif d'équilibrage de température selon la revendication 11, **caractérisé en ce que** le système de commande est configuré de façon à pouvoir commander ou réguler une puissance d'équilibrage de température variable par une excitation variable des ventilateurs (13, 13') et/ou par une commande variable du courant fourni aux éléments régulateurs de température (10).

13. Dispositif d'équilibrage de température selon la revendication 12 ou la revendication 13, **caractérisé en ce que** les modules d'équilibrage de température (1) peuvent être commandés de manière différente les uns des autres au moyen du système de commande.

14. Dispositif d'équilibrage de température selon l'une des revendications 11 à 13, **caractérisé en ce que** le système de commande est configuré pour exciter les ventilateurs (13, 13') avec une puissance électrique variable et pour exciter les éléments régulateurs de température (10) avec une puissance électrique variable afin de couvrir un besoin en puissance d'équilibrage de température variable, et **en ce que** l'excitation des ventilateurs (13, 13') et l'excitation des éléments régulateurs de température (10) sont adaptées l'une en fonction de l'autre de manière à minimiser le besoin total en puissance électrique pour l'excitation des ventilateurs (13, 13') et des éléments régulateurs de température (10) pour la puissance d'équilibrage de température considérée.

15. Dispositif d'équilibrage de température selon l'une des revendications 11 à 14, **caractérisé en ce que** le système de commande comporte au moins une unité de commande (41) réalisée sous la forme d'un microcontrôleur dans laquelle sont stockés des programmes servant à fournir les signaux nécessaires à l'excitation des ventilateurs (13, 13') et des éléments régulateurs de température (10) en fonction de signaux de capteurs indiquant le besoin en puissance d'équilibrage de température.

16. Dispositif d'équilibrage de température selon l'une des revendications précédentes, **caractérisé en ce qu'**il est prévu une alimentation en énergie électrique qui comprend au moins un module d'alimentation en énergie (30, 30'), le ou lesdits modules d'alimentation en énergie étant configurés pour alimenter au choix un module d'équilibrage de température (1) individuel ou un groupe de modules d'équilibrage de température (1).

17. Dispositif d'équilibrage de température selon l'une des revendications 11 à 16, **caractérisé en ce que** le système de commande au moins un module de commande (40) doté de son propre boîtier et **en ce que** le module de commande (40) et/ou le ou les modules d'alimentation en énergie (30, 30') sont également pourvus d'un dispositif d'accouplement (20) pour le couplage électrique et/ou mécanique avec un ou plusieurs modules d'équilibrage de température (1).

18. Dispositif d'équilibrage de température selon l'une des revendications précédentes, **caractérisé en ce que** la partie supérieure de boîtier (7) dépasse vers l'extérieur sur la face supérieure à la manière d'un capot et, vue en coupe longitudinale, possède une forme trapézoïdale ou à courbure convexe vers l'extérieur, et **en ce qu'**il est formé entre un segment central de la partie supérieure de boîtier (7) et une paroi intermédiaire (8), dans la zone supérieure en regard de la partie inférieure de boîtier, une chambre réceptacle dans laquelle est montée une alimentation en énergie électrique, en particulier un bloc d'alimentation secteur (42).

19. Dispositif d'équilibrage de température selon l'une des revendications précédentes, **caractérisé en ce que** un insert de boîtier (9) à contour extérieur parallélépipédique dans lequel les conduits d'écoulement (15, 15') sont formés est introduit dans la partie inférieure de boîtier (7).

20. Dispositif d'équilibrage de température selon la revendication 19, **caractérisé en ce que** l'insert de boîtier (9) est raccourci dans sa direction longitudinale par rapport à la partie inférieure de boîtier (7), et **en ce que** l'unité de commande (41) est reçue dans l'espace entre un petit côté extérieur de l'insert de boîtier (9) et le petit côté intérieur en regard de la partie inférieure de boîtier (7).

21. Dispositif d'équilibrage de température selon l'une des revendications précédentes, **caractérisé en ce qu'**un dispositif indicateur optique est intégré dans une paroi de recouvrement supérieure de la partie supérieure de boîtier (7).
